# EUROPEAN PATENT APPLICATION

(11) **EP 0 727 936 A1**
(43) Date of publication of application: **21.08.1996**
(21) Application number: 96102533.5
(22) Date of filing: 20.02.1996
(51) Int. Cl.: H05K 13/08

(54) **A part recognition device**

(30) Priority: 20.02.1995 JP 30956/95
(71) Applicant: YAMAHA HATSUDOKI KABUSHIKI KAISHA, Iwata-shi Shizuoka-ken, 438 (JP)
(72) Inventor: Hashimoto, Kazuhisa, c/o Yamaha Hatsudoki K.K., Iwata-shi, Shizuoka-ken (JP)
(74) Representative: Grünecker, Kinkeldey, Stockmair & Schwanhäusser Anwaltssozietät

(57) **Abstract**

A part recognition device, especially for a mounting device for mounting electric and/or electronic parts, for example on a printed circuit board comprises a part recognition unit. This part recognition device is further provided with a first lighting means for a transmitted light recognition as well as with a second lighting means for an impinging light recognition of the part by means of said part recognition unit.

## Description

This invention relates to a part recognition device, especially for a mounting device for mounting electric and/or electronic parts, for example on a printed circuit board comprising a part recognition unit.

As a mounter for ICs, one is known which is provided with a head unit capable of moving in the X axis and Y axis directions, with the head unit provided with a plural number of pickup nozzles capable of moving in the Z axis (vertical) and around the R axis (rotary) directions. In such a mounter, the position of the part is detected by taking the image of the underside of the part by a camera In order to compensate relative displacement between the pickup nozzle and the part supported by the pickup nozzle.

For taking the image of the part, two methods are known; one is the back light method in which light is cast from above the part and the silhouette of the part is taken by a camera, and the other is the fore light method in which light is cast from the camera side so as to be reflected from the underside of the part, and the reflected light is used to produce an image.

In recent years, various types of ICs have been provided and for some of them position detection is difficult. An IC called BGA for example has, in place of leads, solder balls arranged in a lattice pattern on the underside. Therefore, its position can be detected only by the fore light method. On the other hand, for some ICs, the position cannot be detected unless the silhouette is recognized, and for others, the position is detected easier by the back light method.

Accordingly, it is an objective of the present invention to provide an improved part recognition device as indicated above which is capable to recognize any type of parts to enhance the capability of said device.

According to the invention, this objective is solved for a part recognition device as indicated above by a first lighting means for transmitted light recognition and a second lighting means for impinging light recognition of a part by means of said part recognition unit.

In order to have a more uniform light, the first lighting means comprises a light source and a diffusion means, whereby according to further advantageous embodiments this diffusion means may be provided with an anti-reflection layer on a surface opposite to said light source which may comprise a plurality of LED's.

According to a further embodiment of the invention, said part recognition unit is a camera having an optical axis or center line which may be aligned with the center line of said second lighting means.

In order to reduce or eliminate the influence of the environment, it is advantageous when said second lighting means comprises a casing the bottom of which faces to said camera and having an open top adjacent to which a part is placable and when the interior wall comprises a light source directed to the open top.

Thereby, it is advantageous when said light source is positioned adjacent said bottom of said facing close to said center axis or in an upper part of said interior wall of said casing or said light source comprises two groups located at both above-mentioned positions.

In order to enhance the brightness of said second lighting means, it is advantageous when the interior wall of said casing comprises diffusion means, whereby in case of two groups of lighting light sources at least one of said groups is connected to a diffusion means.

Since both lighting means may be arrangeable opposing each other, it is advantageous when the diffusion means of the first lighting means comprises an anti-reflection layer, whereby according to an advantageous embodiment said diffusion means is a milky white acrylic plate and when said anti-reflection layer is a layer of matted black paint.

Although said first and second lighting means may be selectively chosen by an operator, it is advantageous when a main controller unit controls said part recognition device.

Other preferred embodiments of the present invention are laid down in further dependent claims.

According to an embodiment of a part recognition device, first the operator or the control means selects which one of the first and second lighting means is to be used according to the type of the part. When the first lighting means is selected, light is emitted from the first lighting means and the position of the part having leads for example is detected by taking the silhouette of the part produced by the light cast on the part with the camera means. When the second lighting means is selected, light is emitted from the second lighting means and reflected for example by the solder balls projecting from the underside of the BGA, and the reflected light is taken by the camera means to recognize the part.

According to another embodiment, since the light emitted from the light source is diffused to be uniform by the diffusion means and cast on the part, the image of the light source cannot be undesirably taken by the camera means. Furthermore, since a reflection prevention layer is provided on the part side surface of the diffusion means, that surface becomes a background which causes the part on which the light from the second lighting means is cast to stand out clearly when the brightness of the surface color is suitably selected.

With a further embodiment, even for a part such as BGA having highly glossy underside, the light from the second light source cannot be reflected from the underside and taken by the camera means. When the part has leads projecting from its side, the light is reflected and taken by the camera means. Furthermore, since a part of the light emitted from the second light source is diffused by the diffusion means and cast from around on the part, the underside of the part such as BGA can be lit brighter.

According to still another embodiment, especially for a part such as BGA having highly glossy underside, since the light emitted from the light source disposed in a position so that the light reflected by the underside of the part does not strike the camera means is diffused by the diffusion means and cast from around on the part, the underside of the part such as BGA can be lit brighter. When the part has leads projecting from its side, the light from the first light source is reflected and taken by the camera means.

In the following, the present invention is explained in greater detail with respect to several embodiments thereof in conjunction with the accompanying drawings, wherein:
FIG. 1 is a block diagram of a circuit of a mounter employing a lighting device for part recognition as an embodiment of this invention.
FIG. 2 is a block diagram of a mounter employing a lighting device for part recognition as the first embodiment of this invention.
FIGs. 3(A), (B) and (C) are explanatory drawings of part detection using the back light method. FIG. 3(A) is a cross-sectional side view of a back light unit. FIG. 3(B) shows a part image taken by a camera. FIG. 3(C) is a side view of a modified example of a diffusion plate.
FIGs. 4(A) and (B) are explanatory drawings of part detection using the fore light method. FIG. 4(A) is a cross-sectional side view of a back light unit. FIG. 4(B) shows a part image taken by a camera.
FIG. 5 is a flow chart of operation of a mounter employing the lighting device for part recognition as an embodiment of this invention.
FIG. 6 is a side view for explaining the function of this invention and the relationship between a part and LEDs and others.
FIG. 7 is another side view for explaining the function of this invention and the relationship between a part and LEDs and others.
FIGs. 8(A) and (B) show the second embodiment of this invention. FIG. 8(A) is a plan view of the fore light. FIG. 8(B) is a cross-sectional side view of the fore light.
FIGs. 9(A) and (B) show the third embodiment of this invention. FIG. 9(A) is a plan view of the fore light. FIG. 9(B) is a cross-sectional side view of the fore light.

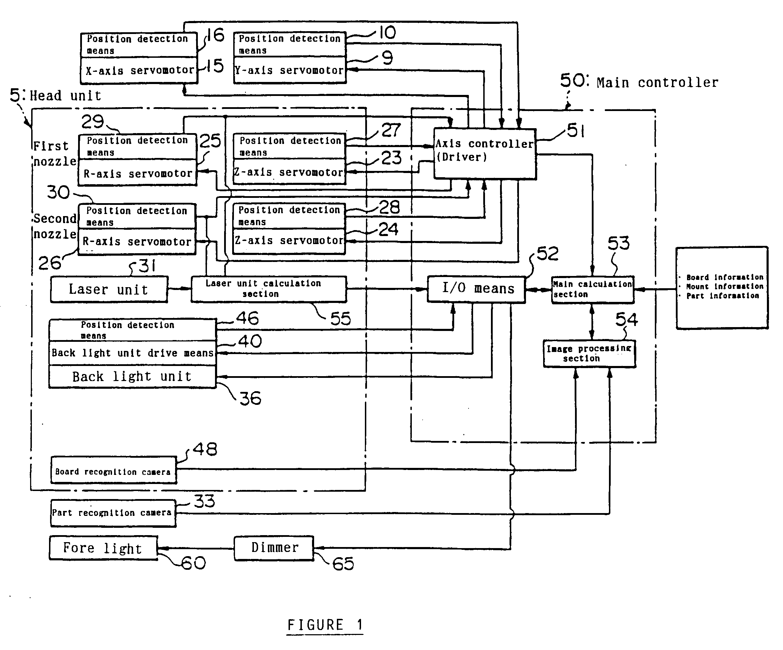

The first embodiment of this invention will be hereinafter described in reference to FIGs. 1 through 5. FIG. 1 is a block diagram showing a circuit structure of a mounter with a lighting device for part recognition of this embodiment. A head unit 5 is attached to an X-Y table (not shown) provided in the mounter and made movable by an X-axis servomotor 15 and a Y-axis servomotor 9 in directions crossing each other at right angles as seen in plan view. The positions of the head unit 5 in the X-axis and Y-axis are detected by pulse signals supplied from position detection means 16, 10 such as encoders. The detected results are fed back to control the X-axis and Y-axis servomotors 15, 9 .

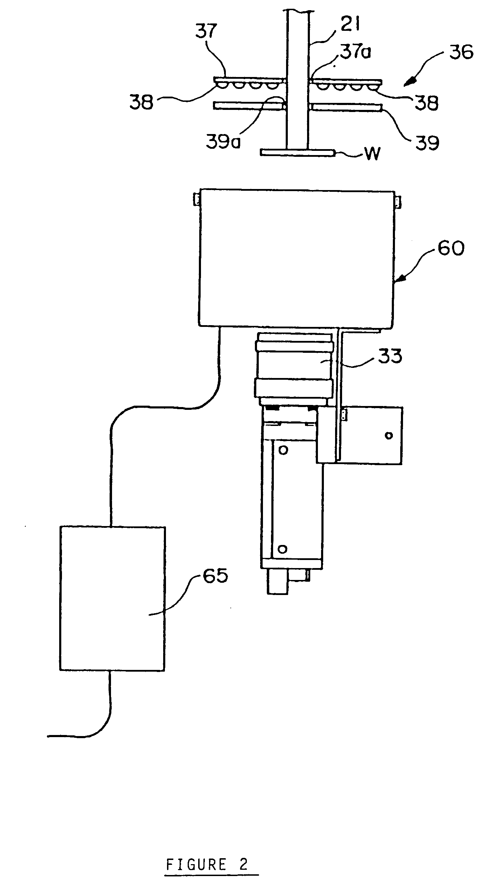

The head unit 5 is provided with a first pickup nozzle (support means, See FIG. 2) and a second pickup nozzle (not shown) respectively made rotatable by R-axis servomotors 25, 26 . The first and second pickup nozzles are adapted to pick up a part W by a vacuum suction mechanism (not shown). The first and second pickup nozzles are also adapted to be moved up and down by Z-axis servomotors 23, 24 . In the drawings are also shown position detection means 29, 30; 27, 28 such as encoders for detecting the positions of the first and second pickup nozzles in the R-axis and Z-axis directions. The position detection means 27 to 30 supply pulse signals in numbers proportional to the amounts of movement in the R-axis and Z-axis directions to a driver 51 of a main control section 50 for controlling the R-axis and Z-axis servomotors 23 to 26 .

The head unit 5 is also provided with a laser unit 31 for detecting the position of the part picked up by the first pickup nozzle 21 or the second pickup nozzle. The laser unit 31 comprises a laser beam generating section (not shown) for casting a coherent light beam on the part W picked up by the first pickup nozzle 21 or the second pickup nozzle, and a light receiving section (not shown) struck by the coherent light beam. The light receiving section supplies signals commensurate with the state of light reception to a laser unit calculating section 55 which in turn calculates the position of the part W picked up by the first pickup nozzle 21 or the second pickup nozzle and supplies the calculated results as position data to a main calculating section (control means) 53 through input-output means 52 . The main calculating section 53 at the time of mounting the part W in a specified position on a printed circuit board, calculates movement amount required for the part W from the position data of the part W , and supplies the calculated results as motor control data to the driver 51 .

The head unit 5 is also provided with a back light unit (the first lighting means) 36 for casting light on the part W picked up by the first nozzle 21 . As shown in FIG. 2, the back light unit 36 is provided with a back light 37 made up of a plural number of LED's (light source) 38 arranged in a lattice pattern with its light emitting section facing downward, and a diffusion plate (diffusion means) 39 disposed apart downward from the back light 37 . The diffusion plate 39 comprises a milky white acrylic plate (diffusion layer), and an acrylic plate colored in gray bonded to the underside of the diffusion layer with its underside subjected to mirror reflection prevention process to make it like frosted glass.

With this constitution, the light emitted from the LED's 38 is cast into the upper acrylic plate and diffused so that the entire acrylic plate shines uniformly in white and lights up the part W . The lower acrylic plate is adapted to be anti-reflective when it is lit by a fore light (second lighting means) 60 which will be described later, so that the light from the light source of the fore light 60 is not mirror-reflected but irregularly reflected by its underside. Since the lower acrylic plate is colored in gray, it constitutes a dark background so that the leads of the part W shining as it reflects cast light are clearly recognizable.

As shown in FIG. 2, the back light 37 and the diffusion plate 39 are respectively provided with holes 37a, 39a for the first pickup nozzle 21 to pass through. The back light unit 36 is adapted to be moved by drive means 40 in the horizontal direction. With this arrangement, the back light unit 36 may be selectively set to a first position when the back light unit 36 is used for detecting the part or to a second position where the back light unit 36 is retracted and the laser unit 31 is used for detecting the part. The head unit 5 is further provided with a printed circuit board recognition camera 48 for recognizing and detecting the position of the printed circuit board. When the printed circuit board recognition camera 48 is used, the back light unit 36 is set to a third position where the back light 37 and the holes 37a, 39a of the diffusion plate 39 face the lens (not shown) of the printed circuit board recognition camera 48 .

The fore light 60 is mounted on the mounter and, as shown in FIG. 2, the head unit 5 is adapted to move to a position above the fore light 60 . The fore light 60 is of a box shape, and over its almost entire inner wall surface are arranged LEDs (light source, not shown) with their light emitting portions directed upward. The amount of light of the fore light 60 is adapted to be adjustable by a dimmer 65 . The fore light 60 is provided with a part recognition camera (hereinafter referred to simply as camera) 33 with its lens center line aligned with the center line of the fore light 60 .

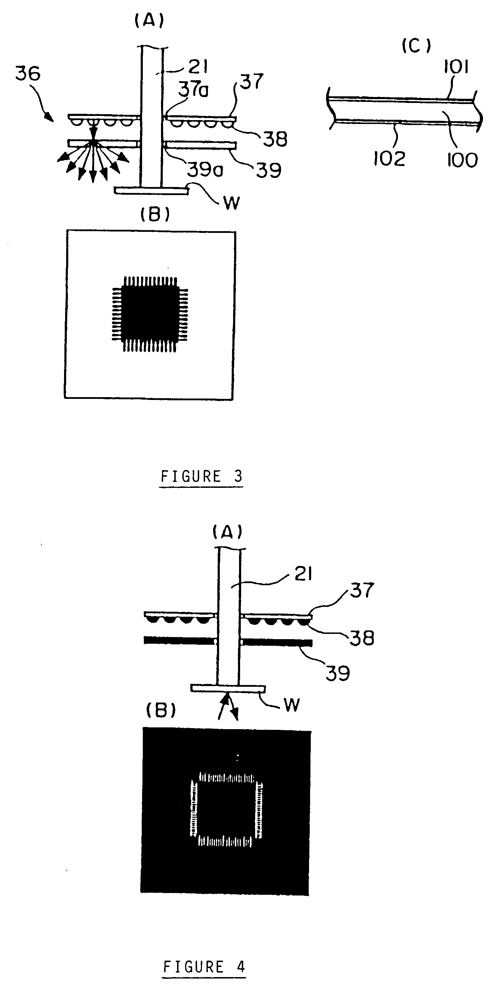

FIG. 4 shows an image of the part W lit by the fore light 60 and taken by the camera 33 . As shown in the drawing, when the fore light (60) is used, the back light 37 is not lit up. Since the underside of the diffusion plate 39 is processed with reflection prevention treatment and colored in gray, the background of the part W looks dark. As the light of the fore light 60 is reflected by the leads of the part W , the leads stand out clearly in the dark background. FIG. 3 shows the image of the part W as it is lit by the back light unit 36 . As shown in the drawing, the diffusion plate 39 is made a white background by the light emitted from the LEDs 38 and the silhouette of the part W stands out clearly in the white background.

The graphic information obtained by taking the image of the part W with the camera 33 is supplied to an image processing section 54 which calculates the position of center of gravity and angle of rotation of the part W through a specified image processing. The image processing section 54 inputs the graphic information of the printed circuit board taken by the printed circuit board recognition camera 48 and calculates the position of the printed circuit board using a position detection mark provided on the printed circuit board.

The information on positions of the part W and the printed circuit board calculated by the image processing section 54 is supplied to a main calculation section (control means) 53 which controls the driver 51 so that the part W is automatically picked up and mounted to the printed circuit board. Here, amount and direction of displacement of the part W is calculated from the position information of the part W and the printed circuit board supplied from the image processing section 54 . The main calculation section 53 also reads printed circuit board information, mounting information, and parts information for such calculation from a memory (not shown).

In other words, information on the printed circuit board such as the printed circuit board size and others is provided by the image processing section 54 for calculating the position information of the printed circuit board, and the mounting information such as the mounting position of the part W on the printed circuit board Is used for calculating the amount and direction of displacement of the part W . From the part information according to the types of ICs, such as BGA, PLCC, QFP, etc., which of the laser unit 31 , back light 37 , and fore light 60 is to be used for detecting the part is determined. When a BGA or PLCC is to be mounted, the fore light 60 is used. For other ICs with leads, for example a QFP with a very short lead pitch, the back light 37 is used. For the parts without leads, the laser unit 31 is used.

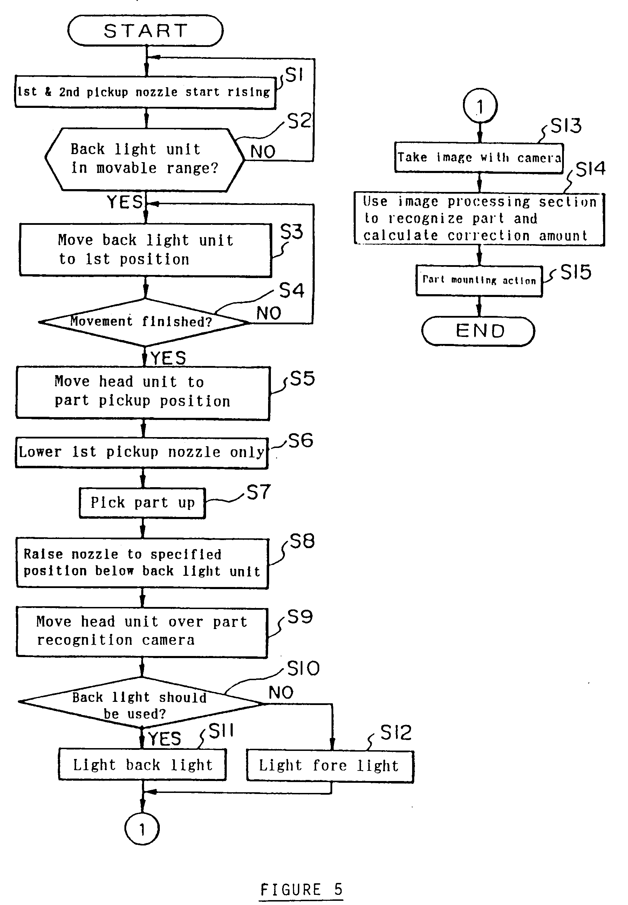

Operation of the mounter of the structure described above will be described below in reference to the flow chart shown in FIG. 5. FIG. 5 shows a process routine when the camera 33 is selected for detecting the position of the part W . At the start of the mounting work, the back light unit 36 is set to the second position displaced from the position below the first pickup nozzle 21 , and the first and second pickup nozzles are in the lowered state. Therefore, the first and second pickup nozzles are raised to avoid interference with the back light unit 36 , and the back light unit 36 is moved (steps S1 - S4).

When the movement of the back light unit 36 to the first position is over, the first pickup nozzle 21 is in a position just above the holes 37a, 39a of the back light 37 and diffusion plate 39 . In that state, the head unit 5 is moved to a part pickup position, and the first pickup nozzle 21 only is lowered. Then, the first pickup nozzle 21 passes through the holes 37a, 39a , reaches the part W , and picks it up (steps S5 - S7).

Next, the first pickup nozzle 21 is raised to a position below the back light unit 36 by a specified distance (step S8). In that state, the head unit 5 is moved to position the part W picked up by the first pickup nozzle 21 above the camera 33 (step S9). Next, which of the back light 37 and the fore light 60 is to be used for the part W to be detected is determined (step S10).

When the part W is an IC of a relatively wide lead pitch for example, the determination result of the step S10 becomes "YES" and the process goes to the step S11 to light up the back light 37 . On the other hand, when the part W is a BGA, the determination result of the step S10 becomes "NO" and the process goes to the step S21 to light up the fore light 60 . Next, the image of the part W is taken by the camera 33 , position and displacement amount of the part W are calculated from the graphic information, the part W is moved and mounted to a specified position on the printed circuit board (steps S13 - S15).

In the lighting device for part recognition of the constitution described above, since the back light 37 or the fore light 60 is selectively used according to the type of the part W , the device provides a wide range of applicability to almost any type of part for position detection. In particular in the above embodiment, since the underside of the diffusion plate 39 is colored dark and processed for irregular reflection, the background when the fore light 60 is used is formed with a very simple arrangement.

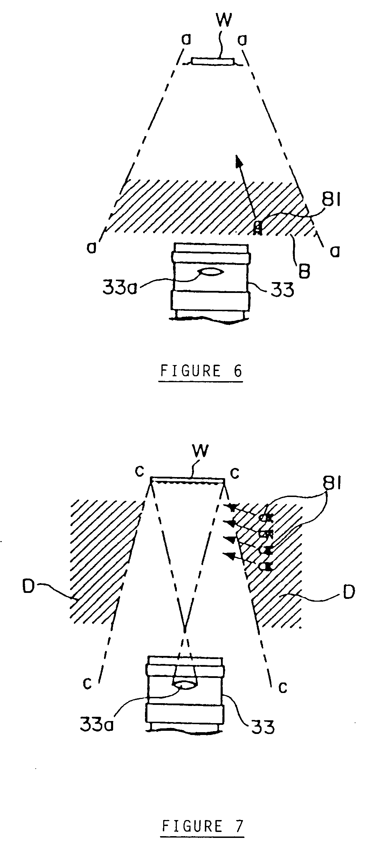

The second embodiment of this invention will be hereinafter described in reference to FIGs. 6 through 8. The second embodiment is characterized by an improvement in the lighting by the fore light for smooth position detection of parts having solder balls on the underside and IC parts with leads projecting from the side.

When the fore light method is used, the light is reflected by the metallic portions of the leads and others and taken as image. As a result, when the incident angle of the light cast on the part from the LEDs of the fore light increases, the amount of light entering the camera lens decreases. Therefore, it is necessary to dispose the LEDs so that the incident angle of the LED light does not exceed a certain value. FIG. 6 shows an arrangement of the LEDs 81 meeting such a requirement. In the drawing, an area B is defined by the lines a-a where the LEDs 81 may be positioned in order that a necessary amount of light reflected by the part W strikes the lens 33a of the camera 33 .

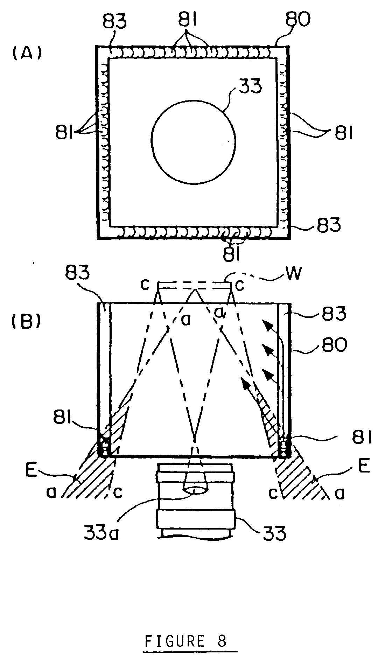

On the other hand, the underside of the BGA is highly glossy as it is coated with transparent plastic or the like. Therefore, if the LEDs 81 are located near the optical axis of the lens 33a of the camera 33 , the image of the LED reflected by the portion of the underside of the BGA other than the solder balls is undesirably taken by the camera. Therefore, when the position of the BGA is to be detected, the LEDs 81 have to be disposed apart from the optical axis. FIG. 7 shows an arrangement of the LEDs 81 meeting such a requirement. In the drawing, the lines c-c defines the area D where the LEDs 81 may be positioned in order that the image of the LEDs 81 is not reflected by the underside of the part W , when it is assumed to be a mirror surface, and taken by the camera. In the second embodiment, the LEDs 81 are located in the area where the area D and the area B described above overlap each other.

FIG. 8 shows details of the fore light of the second embodiment. In the drawing, a casing 80 is of a box shape. On its entire lower inner circumferential surface of the casing 80 are arranged a plural number of LEDs (light source) 81 with their light emitting portions directed upward. The LEDs 81 are disposed In the area where the areas (B) and (D) overlap each other. Therefore, if the part W is one with leads, the light emitted from the LEDs 81 is reflected by the leads and strikes the lens 33a . If the part W is a BGA, the image of the LEDs 81 reflected by the underside of the part W cannot be visible from the lens 33a .

A diffusion plate 83 made of milky white acrylic plate is attached just above the LEDs 81 Part of the light emitted from the LEDs 81 is directly cast toward the part W and the rest is cast on the underside of the diffusion plate 83 . As a result, the light is diffused in the diffusion plate 83 and shines white, and lights up the part W from around as shown with arrows in the drawing. In this embodiment too, the same back light unit 36 is used for the background of the part W .

With the lighting device for part recognition of the structure described above, the same effect as with the first embodiment is obtained as a matter of course. Furthermore, since the LEDs 81 are positioned so as not to be visible from the camera 33 , the image of the LEDs 81 cannot be taken by the camera 33 however strong the underside gloss of the part W may be like that of BGA. Furthermore, since the LEDs 81 are positioned so that their light is reflected by the leads and strikes the lens (33a), even when the part W is with leads, the image of the leads can be taken by the camera. Furthermore, since part of the light emitted from the LEDs 81 is diffused by the acrylic plate and lights up the part W from around, the underside of the part W such as the BGA is lit up brighter. In this way with the second embodiment, undesirable effect of taking the reflected image of the LEDs 81 never occurs, and a clear image of any type of part W can be taken.

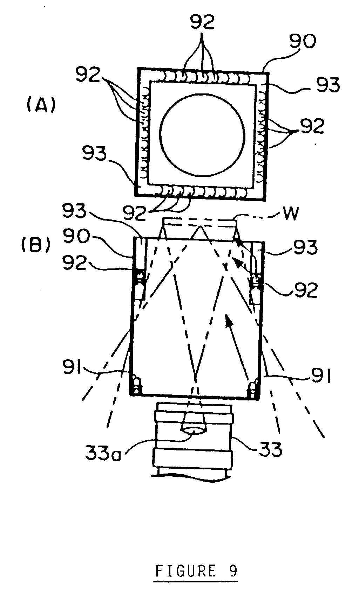

The third embodiment will be hereinafter described in reference to FIG. 9. FIG. 9 shows a fore light in the third embodiment in which a casing 90 is shown. The casing 90 is of a box shape and on its entire lower inner circumferential surface are arranged a plural number of the first group of LEDs first light source 91 with their light emitting portions directed upward. The first group of LEDs 91 is disposed in the area B of FIG. 6 and whether it should be disposed in the area D of FIG. 7 or not is optional.

On the entire upper inner circumferential surface of the casing 90 is arranged the second group of a plural number of LEDs (second light source) 92 with its light emitting portion directed upward. The second group of LEDs 92 is disposed in the area D of FIG. 7 and whether it should be disposed in the area B of FIG. 6 or not is optional. A diffusion plate 93 is disposed just above the second group of LEDs 92 on the inner circumferential surface of the casing 90 . The diffusion plate 93 is made of milky white acrylic plate. The light of the LEDs 92 striking the bottom end surface of the diffusion plate 93 is diffused in the diffusion plate 93 and shines white, and lights up the part W from around as shown with arrows in the drawing.

Which of the first and second groups of LEDs 91 and 92 should be used is determined according to the type of the part W by the main calculation section 53 See FIG. 1). That is to say, when the part W is a BGA, the second group of LEDs 92 is used, and when the part W is an IC with leads projecting from the side, the first group of LEDs 91 is used. In this embodiment too, the same back light unit 36 of the first embodiment is used for the background of the part W .

With the lighting device for part recognition of the structure described above, the same effect as with the first embodiment is obtained as a matter of course. Furthermore, since the second group of LEDs 92 is positioned so as not to be visible from the camera 33 , the image of the second group of LEDs 92 cannot be taken by the camera 33 however strong the underside gloss of the part W may be like that of BGA. Furthermore, since the light from the second group of LEDs 92 is diffused by the acrylic diffusion plate 93 and lights up the underside of the part W from around, the underside of the part W is lit up brighter. Furthermore, when the part W is an IC with leads, the light from the first group of LEDs 91 is reflected by the leads and the image is taken by the camera 33 . In this way, undesirable effect of taking the reflected images of the first and second groups of LEDs 91 and 92 never occurs, and a clear image of any type of part W can be taken.

This invention is not limited o the embodiments described above but may be modified in various ways. For example, in the second and third embodiments, the LEDs may be embedded in the diffusion plate. In this way, the light emitted from the LEDs can be effectively cast on the part W . In the third embodiment in which the diffusion plate 93 is provided above the second group of LEDs 92 the diffusion plate 93 may be omitted to produce the same effect.
(1) In the first embodiment, the milky white acrylic plate is used as the diffusion plate 39 . However, as shown in FIG. 3 C , a colored (gray, for example) transparent acrylic plate 100 may be used with its top side provided with a diffusion layer 101 and with its underside provided with a reflection prevention layer 102 . In that case, the diffusion layer 101 may be constituted by applying commercially available diffusion paint.
(2) The mirror reflection prevention layer 102 may be constituted by applying sand blasting on the underside of the gray acrylic plate 100 to form like frosted glass or applying matted paint.
(3) The most preferable example of the diffusion plate which may be mentioned is a milky white acrylic plate with its underside applied with matted black paint. This can reduce manufacturing cost in comparison with the one of the first embodiment in which two acrylic plates are laminated or the one using the gray acrylic plate. Furthermore, use of a single acrylic plate can reduce the thickness of the diffusion plate. This makes it possible to provide a large distance between the diffusion plate and the LEDs so that the light from the LEDs is well diffused before it reaches the diffusion plate and a more uniform light emitting surface is obtained.

With the lighting device for part recognition of this invention described above, advantages of both back light method and fore light method are provided so that position of any type of part may be detected and excellent effects are provided such as the capability of constituting a mounter which can be applied to every type of parts.

## Claims

1. A part recognition device, especially for a mounting device for mounting electric and/or electronic parts (W) for example on a printed circuit board comprising a part recognition unit (33), **characterized by** a first lighting means (36) for transmitted light recognition and a second lighting means (60) for impinging light recognition of a part by means of said part recognition unit (33).

2. A part recognition device according to claim 1, **characterized in that** said first lighting means (36) comprises a light source (38) and a diffusion means (39; 100).

3. A part recognition device according to claim 2, **characterized in that** said diffusion means (39; 100) is provided with an anti-reflection layer (102) on a surface opposite to said light source (38).

4. A part recognition device according to claim 2 or 3, **characterized in that** said light source comprises a plurality of LED's (38).

5. A part recognition device according to at least one of claims 1 to 4, **characterized in that** said first lighting means (36) comprises holes (37a, 39a) through which pickup means (21) are insertable for supporting a part (W) to be recognized.

6. A part recognition device according to at least one of claims 1 to 5, **characterized in that** said first lighting means (36) is horizontally movable by drive means (40).

7. A part recognition device according to at least one of claims 1 to 6, **characterized in that** said part recognition unit is a camera (33).

8. A part recognition device according to claim 7, **characterized in that** the optical axis or center line of said camera (33) is aligned with the center line of said second lighting means (60).

9. A part recognition device according to claim 7 or 8, **characterized in that** said second lighting means (60) comprises a casing (80) the bottom of which faces to said camera (33) and having an open top adjacent to which a part (W) is placable and that the interior wall comprises a light source (81) directed to the open top.

10. A part recognition device according to claim 9, **characterized in that** said light source (81) is positioned adjacent said bottom of said casing (80) close to said center axis so that most of the emitted light is reflectable by an insertable part (W) to said camera (33).

11. A part recognition device according to claim 9, **characterized in that** said light source (81) is positioned in the upper part of said interior wall of said casing (80).

12. A part recognition device according to claim 10, **characterized in that** the interior wall of said casing comprises diffusion means (83).

13. A part recognition device according to claim 7 or 8, **characterized in that** said second lighting means comprises a casing (90) the bottom of which is provided with said camera (33) and having an open top adjacent to which a part (W) is placable, a first group of light sources (91) positioned adjacent said bottom and a second group of light sources (92) positioned adjacent said open top at the interior wall of said casing (90).

14. A part recognition device according to claim 13, **characterized in that** said second group of light sources (91) is connected to a diffusion means (93) arranged at the upper portion of said interior wall.

15. A part recognition device according to at least one of claims 2 to 14, **characterized in that** said diffusion means (39) of said first lighting means comprises a transparent acrylic plate (100) having at least a diffusion layer (101) opposing said light source (38) and an anti-reflection layer (102) opposite to said diffusion layer (101).

16. A part recognition device according to claim 15, **characterized in that** said acrylic plate is a milky white acrylic plate (100) constituting said diffusion layer (101) and that said anti-reflection layer (102) is a layer of matted black paint.

17. A part recognition device according to at least one of claims 1 to 16, **characterized in that** said first lighting means (36) and said second lighting means (60) is selectively operable.

18. A part recognition device according to at least one of claims 1 to 17, **characterized by** a main controller unit (50) for controlling said part recognition device.
